# EUROPEAN PATENT APPLICATION

(11) **EP 2 722 894 A1**
(43) Date of publication of application: **23.04.2014**
(21) Application number: 12801272.1
(22) Date of filing: 31.05.2012
(51) Int. Cl.: H01L 31/04

(54) **CZTS THIN FILM SOLAR CELL AND MANUFACTURING METHOD THEREOF**

(30) Priority: 16.06.2011 JP 2011134446
(71) Applicant: Showa Shell Sekiyu K.K., Tokyo 135-8074 (JP)
(72) Inventor: SUGIMOTO, Hiroki, Tokyo 135-8074 (JP); SAKAI, Noriyuki, Tokyo 135-8074 (JP); HIROI, Homare, Tokyo 135-8074 (JP)
(74) Representative: HOFFMANN EITLE
(86) International application number: PCT/JP2012/064182
(87) International publication number: WO 2012/172999

(57) **Abstract**

A thin film solar cell comprises a metal rear surface electrode layer formed on a substrate, a p-type CZTS light-absorbing layer formed on the electrode layer, an n-type high-resistance buffer layer containing a zinc compound as a material and formed on the p-type CZTS light-absorbing layer, and an n-type transparent electroconductive film formed on the n-type high-resistance buffer layer. When the Cu-Zn-Sn composition ratio (atom ratio) of the p-type CZTS light-absorbing layer is represented by coordinates with the Cu/(Zn+Sn) ratio shown on the horizontal axis and the Zn/Sn ratio shown on the vertical axis, the ratio is within the region formed by connecting point A (0.825, 1.108), point B (1.004, 0.905), point C (1.004, 1.108), point E (0.75, 1.6), and point D (0.65, 1.5), and the Zn/Sn ratio of the p-type CZTS light-absorbing layer surface in the n-type high-resistance buffer layer is 1.11 or less.

## Description

### Technical Field

The present invention relates to a CZTS-based thin film solar cell and a method of production of the same, more particularly relates to a high photovoltaic conversion efficiency CZTS-based thin film solar cell and a method for producing the same.

### Background Art

In recent years, thin film solar cells which use p-type light absorption layers constituted by chalcogenide-based compound semiconductors generally called "CZTS" have come under the spotlight. This type of solar cell is made from relatively inexpensive materials and has a band gap energy which is suitable for sunlight, so holds the promise of inexpensive production of high efficiency solar cells. CZTS is a Group I₂-II-IV-VI₄ compound semiconductor which includes Cu, Zn, Sn, and S. As typical types, there are Cu₂ZnSnS₄ etc.

A CZTS-based thin film solar cell is formed by forming a metal back surface electrode layer on a substrate, forming on top of that a p-type CZTS-based light absorption layer, and further successively stacking an n-type high resistance buffer layer and n-type transparent conductive film. As the metal back surface electrode layer material, molybdenum (Mo) or titanium (Ti), chrome (Cr), or another high corrosion resistance and high melting point metal is used. A p-type CZTS-based light absorption layer is, for example, formed by forming a Cu-Zn-Sn or Cu-Zn-Sn-S precursor film by the sputter method etc. on the substrate on which the molybdenum (Mo) metal back surface electrode layer has been formed and by sulfurizing this in a hydrogen sulfide atmosphere (for example, see PLT 1).

Here, to improve a CZTS-based thin film solar cell in photovoltaic conversion efficiency, optimization of the ratio of composition of the elements which form the p-type CZTS-based light absorption layer, that is, Cu, Zn, Sn, and S (sulfur or selenium), in particular the ratio of composition of Cu, Zn, and Sn, is important. Regarding this point, in the above PLT 1, the Cu-Zn-Sn composition ratio (atomic ratio) is expressed as the Cu/(Zn+Sn) ratio and the Zn/Sn ratio. It is reported that a high photovoltaic conversion efficiency CZTS-based thin film solar cell is obtained when the Cu/(Zn+Sn) ratio is 0.78 to 0.90 and the Zn/Sn ratio is 1.18 to 1.32.

### Citations List

### Patent Literature

PLT 1: Japanese Patent Publication No. 2010-215497A

### Summary of Invention

### Technical Problem

In the above PLT 1, the Cu-Zn-Sn composition ratio at the p-type CZTS-based light absorption layer is specified to obtain a CZTS-based thin film solar cell which has a high photovoltaic conversion efficiency. In this case, as the n-type high resistance buffer layer which is formed on the p-type CZTS-based light absorption layer, mainly CdS is used. As is well known, Cd (cadmium) is highly toxic and has a large impact on the environment, so a Cd-free solar cell is desired. In PLT 1, several Cd-free zinc-based compounds are proposed as buffer layers, but CdS is considered particularly suitable as a buffer layer.

The present invention has as its object the provision of a CZTS-based thin film solar cell which does not use CdS as an n-type high resistance buffer layer and which has a high photovoltaic conversion efficiency and the provision of a method of production of the same.

### Solution to Problem

To solve the above problem, in a first aspect of the present invention, there is provided a CZTS-based thin film solar cell which is provided with a metal back surface electrode layer which is formed on a substrate, a p-type CZTS-based light absorption layer which is formed on the metal back surface electrode layer, an n-type high resistance buffer layer which uses a zinc compound as a material and which is formed on the p-type CZTS-based light absorption layer, and an n-type transparent conductive film which is formed on the n-type high resistance buffer layer, wherein when expressing a Cu-Zn-Sn composition ratio (atomic ratio) of the p-type CZTS-based light absorption layer by coordinates using the Cu/(Zn+Sn) ratio as the abscissa and the Zn/Sn ratio as the ordinate, it is within a region connecting a point A (0.825, 1.108), a point B (1.004, 0.905), a point C (1.004, 1.108), a point E (0.75, 1.6), and a point D (0.65, 1.5) and wherein further the Zn/Sn ratio of the surface of the p-type CZTS-based light absorption layer at the side which faces the n-type high resistance buffer layer is made 1.11 or less.

In the above aspect, the zinc compound may be Zn(S, O, OH). Further, the region of the surface of the p-type CZTS-based light absorption layer where the Zn/Sn ratio is 1.11 or less may be made a 30 nm range from the interface of the n-type high resistance buffer layer.

To solve the above problem, in a second aspect of the present invention, there is provided a method of production of a CZTS-based thin film solar cell which comprises forming a metal back surface electrode layer on a substrate, forming on the metal back surface electrode layer a metal precursor film which includes at least Cu, Zn, and Sn which is selected so that, when expressed by coordinates using a Cu/(Zn+Sn) ratio as the abscissa and a Zn/Sn ratio as the ordinate, a Cu-Zn-Sn composition ratio (atomic ratio) falls in a region connecting a point A (0.825, 1.108), a point B (1.004, 0.905), a point C (1.004, 1.108), a point E (0.75, 1.6), and a point D (0.65, 1.5), sulfurizing and/or selenizing the metal precursor film to form a p-type CZTS-based light absorption layer, forming on the p-type CZTS-based light absorption layer an n-type high resistance buffer layer of a zinc compound, and forming on the n-type high resistance buffer layer an n-type transparent conductive film, wherein when the metal precursor film has a Zn/Sn ratio over 1.11, after formation of the p-type CZTS-based light absorption layer and before formation of the n-type high resistance buffer layer, the method performs treatment to add Sn to the surface of the p-type CZTS-based light absorption layer on the n-type high resistance buffer layer side so as to form a region with a Zn/Sn ratio of 1.11 or less, then form the n-type transparent conductive film.

In the second aspect, the treatment to add Sn may be dipping the p-type CZTS-based light absorption layer in an SnCl aqueous solution, then annealing it. Further, the zinc compound may be Zn(S, O, OH). Furthermore, the metal precursor film may be formed by successively sputtering ZnS, Sn, and Cu in that order on the metal back surface electrodes.

### Advantageous Effects of Invention

When expressing a Cu-Zn-Sn composition ratio in a p-type CZTS-based light absorption layer or a metal precursor film by coordinates using a Cu/(Zn+Sn) ratio as the abscissa and a Zn/Sn ratio as the ordinate, it is possible to select the ratio so that it falls in the region which connects a point A (0.825, 1.108), a point B (1.004, 0.905), a point C (1.004, 1.108), a point E (0.75, 1.6), and a point D (0.65, 1.5) and make the Zn/Sn ratio of the surface of the p-type CZTS-based light absorption layer at the side which faces the n-type high resistance buffer layer 1.11 or less so that it is possible to obtain a CZTS-based thin film solar cell which achieves a high photovoltaic conversion efficiency (Eff) even if forming an n-type high resistance buffer layer by a zinc compound. As a result, it is possible to provide a CZTS-based thin film solar cell which does not contain Cd with its detrimental effect on the environment and which is suitable for practical use.

### Brief Description of Drawings

FIG. 1 is a schematic view which shows a cross-sectional structure of a CZTS-based thin film solar cell according to a first embodiment of the present invention.
FIG. 2 provides a table which shows the relationship between a Cu-Zn-Sn composition ratio and a photovoltaic conversion efficiency (Eff) in various Cd-free CZTS-based thin film solar cells.
FIG. 3 is a view which maps the data which is shown in FIG. 2 on coordinates having the Cu/(Zn+Sn) ratio as an abscissa and the Zn/Sn ratio as the ordinate.
FIG. 4(a) is a view for explaining the method of production according to the first embodiment of the present invention.
FIG. 4(b) is a view which shows an SnCl treatment CBD process which is used in a second embodiment of the present invention.
FIG. 5(a) is a view which shows profiles of elements in a depth direction in a p-type CZTS-based light absorption layer not subjected to SnCl treatment.
FIG. 5(b) is a view which shows profiles of elements in a depth direction in a p-type CZTS-based light absorption layer obtained by performing a concentration 0.1 mol/liter SnCl treatment CBD process for 1 minute.
FIG. 5(c) is a view which shows profiles of elements in a depth direction in a p-type CZTS-based light absorption layer obtained by performing a concentration 0.1 mol/liter SnCl treatment CBD process for 5 minutes.
FIG. 5(d) is a view which shows profiles of elements in a depth direction in a p-type CZTS-based light absorption layer obtained by performing a concentration 0.1 mol/liter SnCl treatment CBD process for 15 minutes.
FIG. 6 is a view which shows an optimum composition ratio region in a second embodiment.

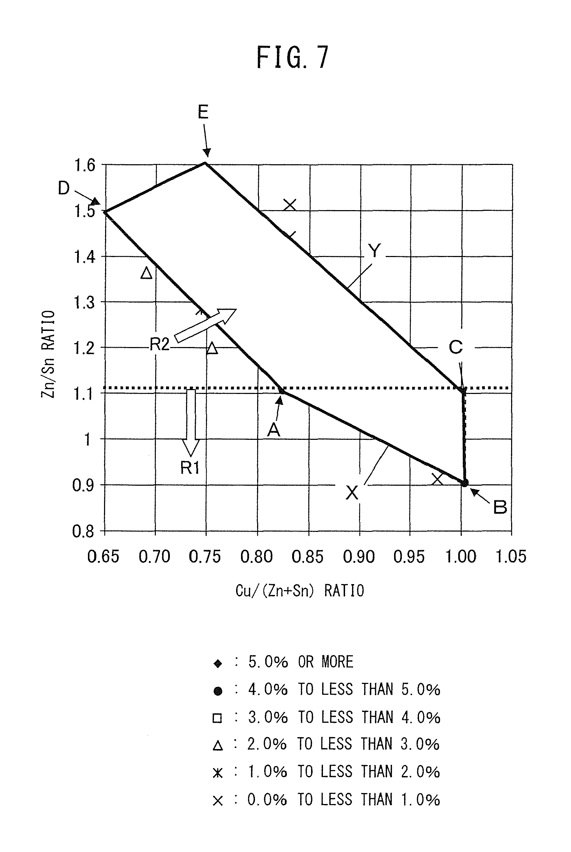

FIG. 7 is a view which shows the optimum composition ratio region in the present invention combining the first embodiment and second embodiment.

### Description of Embodiments

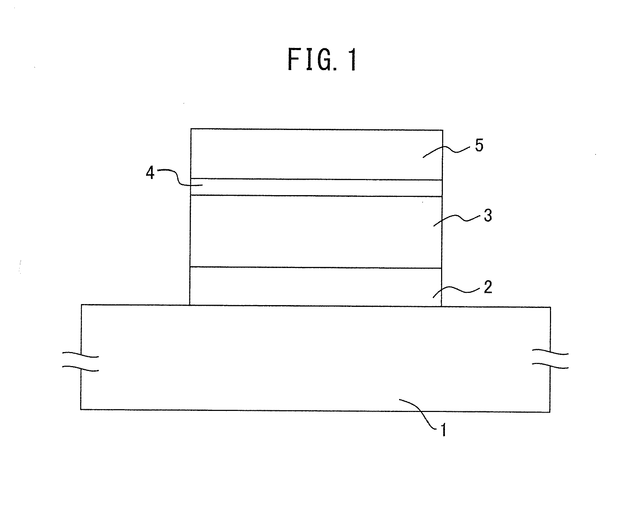

Below, various embodiments of the present invention will be explained with reference to the drawings, but these embodiments are merely examples and do not limit the present invention. Further, the structure which is shown in FIG. 1 is meant only for explaining the present invention. The sizes of the layers in the drawing do not correspond to the actual scale.

Below, a CZTS-based thin film solar cell according to a first embodiment of the present invention and a method of production of the same will be explained. FIG. 1 is a cross-sectional view which shows the schematic structure of a CZTS-based thin film solar cell according to the first embodiment of the present invention. In FIG. 1, 1 indicates a glass substrate, 2 a metal back surface electrode layer which uses Mo or another metal as its material, 3 a p-type CZTS-based light absorption layer, 4 an n-type high resistance buffer layer, and 5 an n-type transparent conductive film. The p-type CZTS-based light absorption layer 3 is, for example, formed by forming a metal precursor film which includes Cu, Zn, and Sn on the metal back surface electrode layer 2, then sulfurizing and/or selenizing it.

In the CZTS-based thin film solar cell which is shown in FIG. 1, the n-type high resistance buffer layer 4 is usually formed using CdS as a material. However, CdS includes the strongly toxic Cd and places a large load on the environment, so in the present invention, a Cd-free CZTS-based thin film solar cell is sought. For this reason, in the present invention, Zn(S, O, OH), ZnS, ZnO, Zn(OH)₂, or a zinc compound which is comprised of mixed crystals of these is used to form the n-type high resistance buffer layer 4.

To obtain a high photovoltaic conversion efficiency (Eff) in a CZTS-based thin film solar cell after manufacture, the composition ratio of the Cu-Zn-Sn in the p-type CZTS-based light absorption layer 3 has to be optimized. The above-mentioned PLT 1 proposes an optimum composition ratio relating to this point, so the inventors selected several points among them to prepare a Cd-free CZTS-based thin film solar cell which has an n-type high resistance buffer layer which is formed by a zinc compound, but could not obtain the high photovoltaic conversion efficiency (Eff) which is described in PLT 1.

PLT 1 indicates that an n-type high resistance buffer layer 4 is formed by CdS. As opposed to this, the present application forms an n-type high resistance buffer layer 4 by a zinc compound. The inventors believed that the p-type CZTS-based light absorption layer 3 might change in optimum composition ratio depending on the material of the n-type high resistance buffer layer 4. Based on this, the inventors selected a plurality of composition ratios which greatly exceeded the range of the optimum composition ratio which was pointed out in PLT 1, prepared CZTS-based thin film solar cells by using zinc compounds to form n-type high resistance buffer layers, and measured the photovoltaic conversion efficiency (Eff).

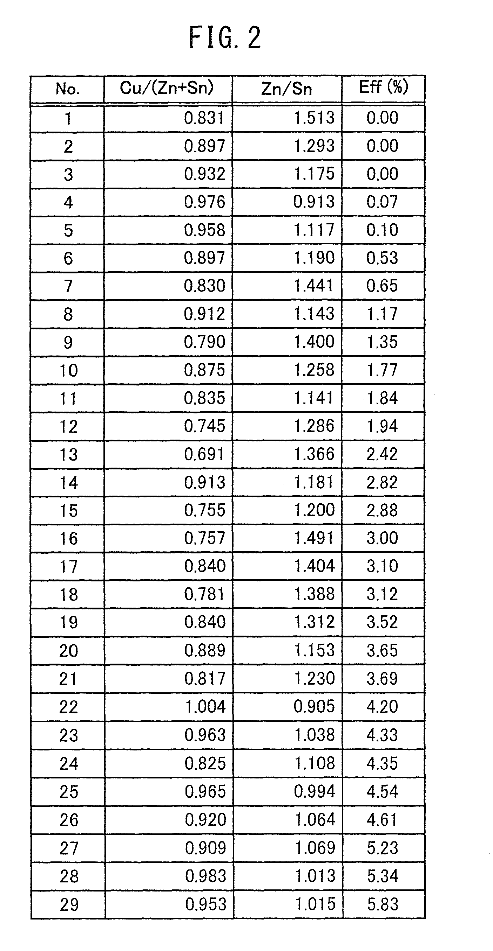

FIG. 2 is a table which shows the relationship between the Cu-Zn-Sn composition ratio and the photovoltaic conversion efficiency (Eff) for 29 CZTS-based thin film solar cell samples which were produced in this way. As the parameters which specify the Cu-Zn-Sn composition ratios, in the same way as PLT 1, the Cu/(Zn+Sn) ratio and the Zn/Sn ratio were employed. These are also all atomic ratios.

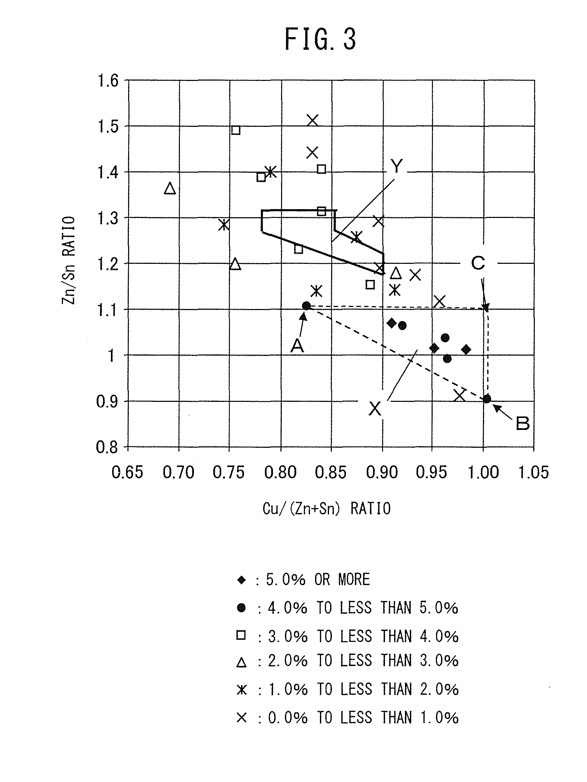

FIG. 3 maps the results which are shown in FIG. 2 on a graph which uses the Zn/Sn ratio and the Cu/(Zn+Sn) ratio as the ordinate and abscissa. In FIG. 3, the ordinate indicates the Zn/Sn ratio, while the abscissa indicates the Cu/(Zn+Sn) ratio. The photovoltaic conversion efficiencies (Eff) of the samples of CZTS-based thin film solar cells which have composition ratios which are specified by the values of the two axes are shown by x, *, △, □, ●, and ◆.

Here, x indicates a sample with a photovoltaic conversion efficiency (Eff) of 0.0% to less than 1.0%, * indicates a sample with a photovoltaic conversion efficiency (Eff) of 1.0% to less than 2.0%, △ indicates a sample with a photovoltaic conversion efficiency (Eff) of 2.0% to less than 3.0%, □ indicates a sample with a photovoltaic conversion efficiency (Eff) of 3.0% to less than 4.0%, ● indicates a sample with a photovoltaic conversion efficiency (Eff) of 4.0% to less than 5.0%, and ◆ indicates a sample with a photovoltaic conversion efficiency (Eff) of 5.0% or more.

In FIG. 3, for reference, the region of the composition ratio which is considered optimal in PLT 1 is indicated by the region Y. As clear from the figure, it is learned that samples with a high photovoltaic conversion efficiency (Eff), for example, an Eff of 4% or more (samples shown by ● and ◆) are present in the region X at the lower region than the region Y which is considered optimal in PLT 1.

In general, in a CZTS-based thin film solar cell, when, in the Cu-Zn-Sn composition ratio, Cu is poor with respect to (Zn+Sn), that is, (Cu/(Zn+Sn)<1), and Zn is greater than Sn, that is, (Zn/Sn>1), it is said that a relatively high photovoltaic conversion efficiency (Eff) is exhibited. In experiments which the inventors ran, the optimal composition region X reaches the lower region than the region Y which is considered the optimal composition ratio in PLT 1, that is, the region where the Cu/(Zn+Sn) ratio reaches 1 or more, and the ratio of Zn and Sn approaches 1 more than the region Y.

This fact suggests that the optimal composition region Y which is shown in PLT 1 and the optimal composition region X found by the experiment which was conducted by the inventors are based on different mechanisms. The solar cell samples which are shown in FIGS. 2 and 3 are basically the same in the method of production as is shown in PLT 1 except for the method of formation of the n-type high resistance buffer layer 4, so it is believed that the difference in the region X and the region Y is derived from the n-type high resistance buffer layer 4. From this, the inventors reached the conclusion that the region X is the inherent optimal composition region when forming the n-type high resistance buffer layer 4 by a zinc compound and the region Y, while not clearly indicated in PLT 1, is the inherent optimal composition region when forming the n-type high resistance buffer layer 4 by CdS.

Note that the composition ratio in the p-type CZTS-based light absorption layer is determined in PLT 1 by fluorescent X-ray analysis of a CZTS-based thin film solar cell product. In the experiment of the present embodiment, it is determined after the formation of the precursor film by inductively coupled plasma spectrometry (ICP). Therefore, the timing of measurement of the composition ratio and the measurement method differ between the two. This difference is also believed to have an effect on the difference in the optimum composition ratio regions. However, regarding this point, the inventors confirmed that there is almost no change in the composition ratio in a p-type CZTS-based light absorption layer between one measured at the time of formation of the precursor film and one measured after completion of the CZTS-based thin film solar cell product.

Furthermore, the inventors used the same method as the method for producing the CZTS-based thin film solar cell of FIGS. 2 and 3 so as to produce CZTS-based thin film solar cells with an n-type high resistance buffer layer of CdS and measured the composition ratios at the p-type CZTS-based light absorption layers by the same method as the case of the CZTS-based thin film solar cells of FIGS. 2 and 3. The results of the experiment are shown in Table 1.

**Table 1.**

| CdS:CZTS-Based Thin Film Solar Cells | | | |
|---|---|---|---|
| | Cu/(Zn+Sn) | Zn/Sn | Eff(%) |
| Experimental data 1 | 0.96 | 1.04 | 4.24 |
| Experimental data 2 | 0.82 | 1.23 | 5.10 |

The sample of the experimental data 1 had a composition ratio at the p-type CZTS-based light absorption layer of Zn/Sn=1.04 and Cu/(Zn+Sn)=0.96. This was positioned outside of the region Y of FIG. 3, that is, the optimum composition ratio region of a CZTS-based thin film solar cell having CdS as the n-type high resistance buffer layer. Therefore, the photovoltaic conversion efficiency (Eff) was also low. On the other hand, the experimental data 2 had a composition ratio in the region Y and exhibited a high photovoltaic conversion efficiency (Eff).

In this way, in the CdS:CZTS-based thin film solar cell which was produced by a method similar to the solar cell samples which are shown in FIGS. 2 and 3 and which was measured for photovoltaic conversion efficiency by a similar method, a sample which is set with a composition ratio of the p-type CZTS-based light absorption layer within the region Y exhibits a high photovoltaic conversion efficiency (Eff), so it is understood that the difference in the region X and the region Y is not based on the difference in the method of production and the method of measurement.

Accordingly, in the CZTS-based thin film solar cell which is shown in FIG. 1, where a zinc compound was selected as the material of the n-type high resistance buffer layer, by selecting the Cu-Zn-Sn composition ratio of the p-type CZTS-based light absorption layer to be within the region X, a CZTS-based thin film solar cell which has a high photovoltaic conversion efficiency (Eff) can be obtained.

The region X which is shown by the broken line in FIG. 3 was set so as to include samples with a photovoltaic conversion efficiency (Eff) of 4.0% or more in the Samples 1 to 29 of FIG. 2. However, even in this area of region, while not performing an experiment, it is possible to rationally set a region where a high photovoltaic conversion efficiency (Eff) can be expected. That is, from the Sample No. 22 (shown by a point A in FIG. 3) and the Sample No. 24 (shown by a point B in FIG. 3), it is possible to make the range of the Cu/(Zn+Sn) ratio 0.825 to 1.004 and make the range of the Zn/Sn ratio 0.905 to 1.108.

However, the area below the line which connects the point A and the point B is the region where Zn becomes smaller compared with Sn. It is considered that there is little possibility of a high photovoltaic conversion efficiency (Eff) being obtained, so this part is eliminated. As a result, it is possible to rationally designate the triangular region having a point C which is defined by the Zn/Sn ratio (=1.108) of the Sample No. 22 and the Zn/Sn value (=0.905) of the Sample No. 23 as a vertex (shown by broken line in FIG. 3) as the optimum composition ratio region X.

Therefore, according to a first embodiment of the present invention, in a CZTS-based thin film solar cell which uses a zinc compound for the n-type high resistance buffer layer, when expressing the composition ratio by the value of Cu/(Zn+Sn) and the value of Zn/Sn, by setting the value to a value in the region X connecting a point A (0.825, 1.108), a point B (1.004, 0.905), and a point C (1.004, 1.108), it is possible to obtain a Cd-free CZTS-based thin film solar cell which has a high photovoltaic conversion efficiency (Eff).

The following Table 2 summarizes the compositions and methods of production of the CZTS-based thin film solar cell samples which are shown in FIGS. 2 and 3.

**Table 2**

| Method of Production of CZTS-Based Thin Film Solar Cell | | |
|---|---|---|
| Substrate 1 | Glass substrate | |
| Metal back surface electrode 2 | Composition | Mo |
| | Thickness | 200 to 500 nm |
| | Film forming method | DC sputter method |
| | Film forming pressure | 0.5 to 2.5 Pa |
| | Film forming power | 1.0 to 3.0W/cm² |
| Metal precursor film 30 | Composition | ZnS, Sn, and Cu are successively formed on Mo |
| | Film forming method | Electron beam deposition method (EB deposition method) |
| Sulfurization | Atmosphere | Hydrogen sulfide gas |
| | Time | 0.5 to 3H |
| | Temperature | 500 to 650°C |
| p-type CZTS-based light absorbing layer 3 | Composition | CU₂ZnSnS₄ |
| | Thickness | 1 to 2 µm |
| n-type high resistance buffer layer 4 | Composition | Zn(S, O, OH) |
| | Thickness | 3 to 50 nm |
| | Film forming method | Chemical bath deposition method (CBD method) |
| n-type transparent conductive film 5 | Composition | i-ZnO(nondoped ZnO)+ BZO (boron doped ZnO) |
| | Thickness | 0.5 to 2.5 µm |
| | Film forming method | MOCVD method |

Note that, the composition ratio of the p-type CZTS-based light absorption layer 3 can be controlled when forming the precursor film by adjusting the amounts of film formation of ZnS, Sn, and Cu. The precursor film is sulfurized in a hydrogen sulfide atmosphere whereby a p-type CZTS-based light absorption layer is formed.

The compositions, manufacturing conditions, etc. which are shown in Table 2 are ones used for obtaining samples of the solar cells which are shown in FIGS. 2 and 3, but the present invention is not limited to the compositions, manufacturing conditions, etc. which are shown in Table 2. That is, as the substrate 1, a soda-lime glass, low alkali glass, or other glass substrate and also a stainless steel sheet or other metal substrate, polyimide resin substrate, etc. may be used. As the method of forming the metal back surface electrode layer 2, in addition to the DC sputter method which is described in Table 2, there are the electron beam deposition method, atomic layer deposition method (ALD method), etc. As the material of the metal back surface electrode layer 2, a high corrosion resistant and high melting point metal such as chrome (Cr), titanium (Ti), etc. may be used

Further, as the method of forming a metal precursor film, instead of the ZnS which is shown in Table 2, Zn or ZnSe may also be used, while instead of the Sn, SnS or SnSe may also be used. Further, other than successively forming Zn, Sn, and Cu films, it is possible to use a vapor deposition source comprised of Zn and Sn alloyed in advance. As the film forming method, in addition to EB deposition, the sputter method may be used as well.

The n-type high resistance buffer layer 4 is generally formed by a chemical bath deposition method (CBD method), but as dry processes, the metal organic chemical vapor deposition method (MOCVD method) and the atomic layer deposition method (ALD method) may also be applied. The CBD method dips a base material in a solution which contains chemical species which form a precursor and causes an uneven reaction to progress between the solution and the surface of the base material so as to cause a thin film to precipitate on the base material.

The n-type transparent conductive film 5 is formed to a thickness of 0.05 to 2.5 µm by using a material which has n-type conductivity, has a broad band gap, and is transparent and low in resistance. Typically, there is a zinc oxide-based thin film (ZnO) or ITO thin film. In the case of a ZnO film, a Group III element (for example, Al, Ga, B) is added as a dopant to obtain a low resistance film. The n-type transparent conductive film 5 may also be formed by the sputter method (DC, RF) etc. in addition to the MOCVD method. Further, the n-type transparent conductive film 5 of the present embodiment has an intrinsic ZnO film (i-ZnO) of a thickness of 0.1 to 0.2 µm to which no dopant of a Group III element is added at a part adjoining the n-type high resistance buffer layer 4. In the present embodiment, an i-ZnO film is continuously formed by the same MOCVD method as the above low resistance film to which the Group III element is added as a dopant. Note that the i-ZnO film can be formed by the sputter method etc. other than the MOCVD. Furthermore, in a CZTS-based thin film solar cell, the i-ZnO film is not an essential constituent and may be omitted.

In the above embodiments, the optimum region X (see FIG. 3) was shown for the range of Cu-Zn-Sn composition ratio of the p-type CZTS-based light absorption layer 3 as a whole for the case of forming the n-type high resistance buffer layer 4 by a zinc compound. However, the composition ratio of the p-type CZTS-based light absorption layer 3 as a whole does not necessarily have to be set uniformly to a value within the region X. For example, it is also possible to change the Cu-Zn-Sn composition ratio in the p-type CZTS-based light absorption layer 3. In this case, at the light receiving surface side of the p-type CZTS-based light absorption layer 3, that is, the part adjoining the n-type high resistance buffer layer 4, the Cu-Zn-Sn composition ratio may be made a value in the region X, while at parts other than the light receiving surface side, that is, the center part in the thickness direction of the p-type CZTS-based light absorption layer 3 and the part at the metal back surface electrode layer 2 side, the Cu-Zn-Sn composition ratio may be made a value shifted in the region Y (see FIG. 3) direction exceeding the region X. In other words, the Cu-Zn-Sn composition ratio may be changed so that the Cu/(Zn+Sn) ratio becomes smaller and the Zn/Sn ratio becomes larger from the light receiving surface side toward the back surface side.

The inventors thought that in Sample Nos. 22 to 29 which are shown in FIG. 2 and FIG. 3, at the very least, at the light receiving surface side of the p-type CZTS-based light absorption layer 3 which forms a pn junction with the n-type high resistance buffer layer 4, the Cu-Zn-Sn composition ratio is a value in the region X, so a high photovoltaic conversion efficiency (Eff) is obtained. Therefore, by making the Cu-Zn-Sn composition ratio of the light receiving surface side part of the p-type CZTS-based light absorption layer 3 which contacts the n-type high resistance buffer layer 4 a value within the region X and making the Cu-Zn-Sn composition ratio shifted in the region Y direction from the light receiving surface side toward the back surface side, a CZTS-based thin film solar cell which has a further higher photovoltaic conversion efficiency (Eff) can be obtained.

As the method for making the Cu-Zn-Sn composition ratio of the p-type CZTS-based light absorption layer 3 change from the light receiving surface side (n-type high resistance buffer layer 4 side) toward the back surface side (metal back surface electrode layer 2 side), for example, there is the simultaneous vapor deposition method.

Below, a CZTS-based thin film solar cell according to a second embodiment of the present invention and a method of production of the same will be explained.

As suggested in the section on the first embodiment, when making the Cu-Zn-Sn composition ratio of the surface of the p-type CZTS-based light absorption layer 3 at the light receiving surface side a value in the region X of FIG. 3 while making the Cu-Zn-Sn composition ratio of the p-type CZTS-based light absorption layer 3 as a whole shift in the region Y direction, there is a possibility that a CZTS-based thin film solar cell which has a high photovoltaic conversion efficiency will be obtained. That is, there is a possibility that the optimum composition ratio region X which was specified in the first embodiment can be made to shift in the region Y direction and further to a region over the Y-direction. To verify this possibility and obtain more superior CZTS-based thin film solar cells, the inventors ran the following experiment and proposed a second embodiment of the present invention based on the results.

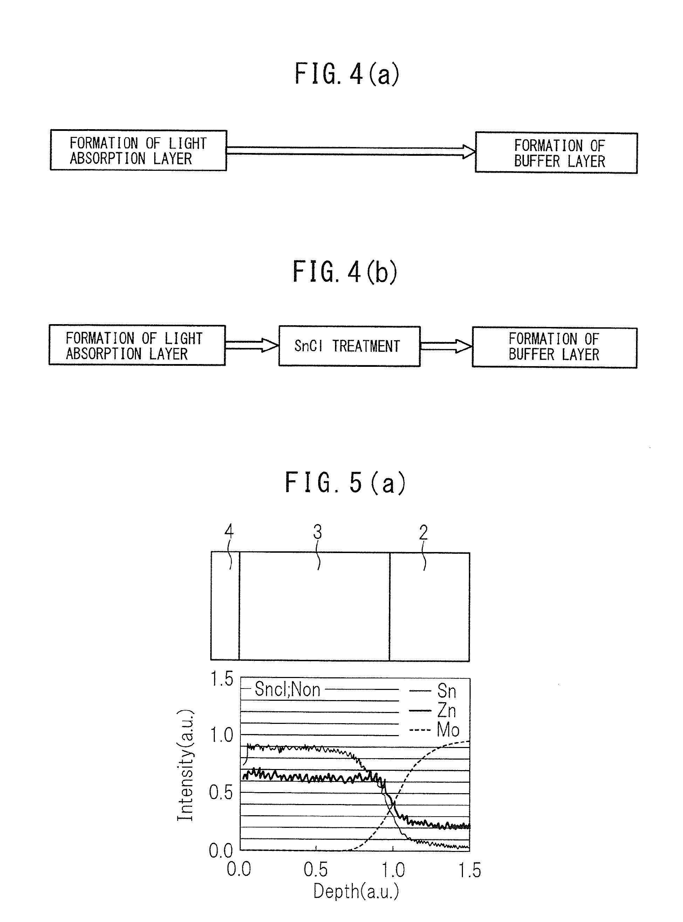

FIG. 4 is a view which shows a summary of this experiment. FIG. 4(a) shows, for comparison, part of the production process according to the first embodiment. As explained above, in the first embodiment, after forming the metal precursor film, this is sulfurized/selenized to form a p-type CZTS-based light absorption layer 3, then for example the CBD method etc. is used to form a Zn-based n-type high resistance buffer layer 4. On the other hand, in the process which is shown in FIG. 4(b), for example, the same procedure as in the case of the first embodiment is performed to form the p-type CZTS-based light absorption layer 3, then this is dipped in an SnCl aqueous solution for a certain time and further is annealed for a certain period to vaporize the Cl, then the same procedure was followed as in the first embodiment to for example use the CBD method to form the Zn-based n-type high resistance buffer layer 4. The dipping of the p-type CZTS-based light absorption layer 3 in the SnCl aqueous solution and the subsequently annealing will be referred to here as the "SnCl treatment".

The Sn which was added by dipping in an SnCl solution is not easily dispersed into the p-type CZTS-based light absorption layer 3 by annealing. If relatively most of it remains near the light receiving surface, the concentration of Sn near the light receiving surface will rise and the Zn/Sn ratio can be kept low. The inventors thought that by utilizing this, even if shifting the Zn/Sn ratio and Cu/(Zn+Sn) ratio of the p-type CZTS-based light absorption layer 3 as a whole in the direction of the region Y or the direction exceeding that, a low Zn/Sn ratio could be maintained at the interface of the light absorption layer and the Zn-based buffer layer and as a result a CZTS-based thin film solar cell which has a high photovoltaic conversion efficiency can be obtained. Therefore, four types of solar cell samples were prepared for p-type CZTS-based light absorption layers 3 which were prepared by the same compositions and methods of production, that is, one without SnCl treatment, one with dipping in an SnCl solution for a time of 1 minute, one for 5 minutes, and one for 15 minutes. The individual samples were measured for distributions of concentration of Sn and Zn (profiles in thickness direction).

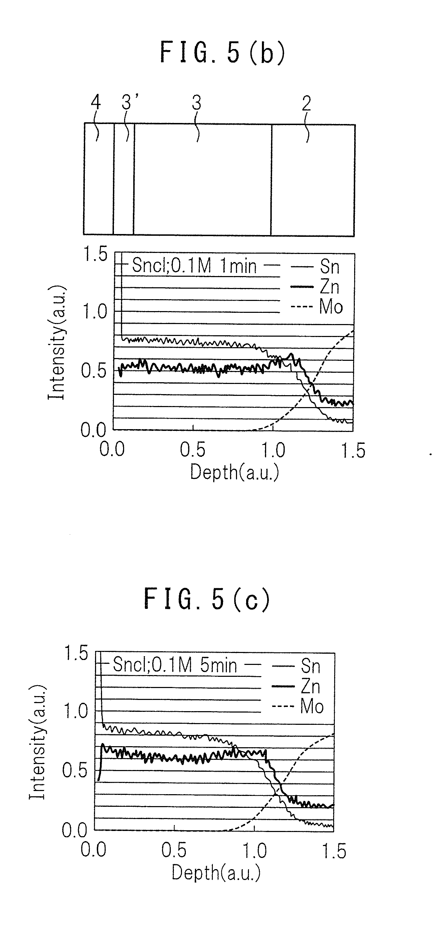

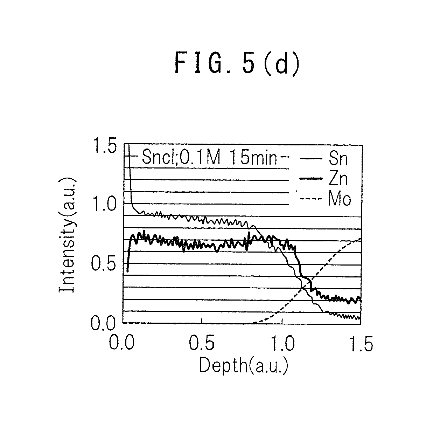

The following Table 3 shows the results of ICP spectrometry of four samples which were prepared in this way. Note that the concentration of the SnCl aqueous solution in the SnCl treatment was 0.1 mol/liter, the solution temperature was room temperature (about 25°C), and the annealing after dipping was performed at 130°C in the air atmosphere for 30 minutes. The Zn/Sn ratio in the 30 nm range from the light receiving surface was found by calculation based on the results of analysis of the samples by the GD method (glow discharge spectrometry) (shown in FIG. 5).

**Table 3**

| SnCl treatment | Zn/Sn | Zn (µmol/cm²) | Sn (µmol/cm²) | Zn/Sn in 30 nm range from light receiving surface |
|---|---|---|---|---|
| None | 1.11 | 0.62 | 0.56 | 1.11 |
| 0.1M-1 min | 1.07 | 0.62 | 0.58 | 0.60 |
| 0.1M-5 min | 1.02 | 0.62 | 0.61 | 0.36 |
| 0.1M-15 min | 0.97 | 0.62 | 0.64 | 0.26 |

| | | | | |
|---|---|---|---|---|
| M: mol/liter | | | | |

FIG. 5 shows the results of analysis of the samples by the GD method, that is, the profiles of the different elements (Sn, Zn, Mo) in the depth direction. The abscissa in FIG. 5 shows the depth in the thickness direction of the p-type CZTS-based light absorption layer 3 by any units (a.u.), while the ordinate shows the intensity of the glow discharge by any units (a.u.) In addition to the profiles of concentration of Sn and Zn in the thickness direction, the profile of concentration of Mo is also shown. This is for showing the position of the Mo back surface electrode layer 2 on the graph. Furthermore, in the graph (a) which shows the results of analysis of samples with no SnCl treatment and the graph (b) of the samples with SnCl treatment at 0.1 mole for 1 minute, the CZTS-based thin film solar cell structures were compared with reference to the depth direction. Note that, in the Zn and Sn profiles of the graphs, the numerical values on the ordinate are arbitrarily set for the elements. Differences between Sn and Zn on the ordinate do not mean absolute or relative differences in concentration of the two.

The graph (c) of FIG. 5 shows the results of analysis in the case of SnCl treatment by 0.1 mol/liter for 5 minutes, while the graph (d) shows the results of analysis in the case of SnCl treatment by 0.1 mol/liter for 15 minutes.

By comparing the graph (a) with the graphs (b) to (d) of FIG. 5, it is learned that in a solar cell sample where the p-type CZTS-based light absorption layer 3 is treated by SnCl treatment, the concentration of Sn rapidly rises near the surface of the p-type CZTS-based light absorption layer 3 at the light receiving side (near interface with Zn-based buffer layer 4), in terms of depth, down to about 30 nm. On the other hand, the distribution of concentration in the thickness direction other than near the surface is substantially constant regardless of the difference in dipping time. There is no great accompanying change in concentration. From these results, it is believed that the Sn which deposited on the p-type CZTS-based light absorption layer 3 by the dipping in the SnCl aqueous solution does not disperse much into the p-type CZTS-based light absorption layer 3 by the subsequent annealing but remains near the layer surface. That is, when treating the p-type CZTS-based light absorption layer 3 by SnCl, then forming a Zn-based buffer layer 4, it is believed that a layer 3' with a low Zn/Sn ratio is formed near the interface with the Zn-based buffer layer 4. The thickness of the p-type CZTS-based light absorption layer 3 as a whole, including the layer 3', was about 700 nm in the illustrated sample.

Based on the above experimental results, Samples 30 to 37 of solar cells were prepared to give Cu-Zn-Sn composition ratios which were shifted to the region Y of FIG. 3 and the region exceeding that region, but were treated by SnCl treatment after formation of the p-type CZTS-based light absorption layer 3 and before formation of the Zn-based buffer layer 4. These were measured for photovoltaic conversion efficiency (Eff). The results are shown in the following Table 4.

**Table 4**

| Sample no. | SnCl treatment | Cu/(Zn+Sn) ratio | Zn/Sn ratio | Photoelectric conversion efficiency Eff (%) | Zn/Sn ratio in 30 nm range from light receiving surface |
|---|---|---|---|---|---|
| 30 | 0.1 M-1 min | 0.71 | 1.53 | 5.14 | 0.68 |
| 31 | 0.1M-15 min | 0.71 | 1.53 | 5.71 | 0.26 |
| 32 | 0.1 M-1 min | 0.70 | 1.52 | 5.12 | 0.69 |
| 33 | 0.1M-15 min | 0.70 | 1.52 | 5.56 | 0.26 |
| 34 | 0.1M-15 min | 0.81 | 1.25 | 4.46 | 0.25 |
| 35 | 0.1M-15 min | 0.78 | 1.32 | 5.58 | 0.25 |
| 36 | 0.1M-15 min | 0.76 | 1.34 | 4.15 | 0.25 |
| 37 | 0.1M-15 min | 0.74 | 1.35 | 4.20 | 0.26 |

The Zn/Sn ratio and the Cu/(Zn+Sn) ratio of Table 4 show the composition ratio of the p-type CZTS-based light absorption layer as a whole (layer 3+layer 3' of FIG. 5(b)). Further, each sample is formed by a similar composition and method of production as the first embodiment other than the SnCl treatment. As the SnCl treatment, the p-type CZTS-based light absorption layer 3 is dipped in a 0.1 mol/liter SnCl aqueous solution of a temperature of room temperature (about 25°C) for 1 minute or 15 minutes, then annealed in a 130°C air atmosphere for 30 minutes to evaporate away the Cl.

Samples 30 to 37 have Cu-Zn-Sn composition ratios at the time of forming the p-type CZTS-based light absorption layers 3 which are selected so as to give Zn/Sn ratios of 1.25 to 1.53 and Cu/(Zn+Sn) ratios of 0.70 to 0.81. This region is beyond the region X which is shown in FIG. 3, but each sample exhibited a high photovoltaic conversion efficiency after production of the solar cell. This is believed to be because the Sn which is added by SnCl treatment of the p-type CZTS-based light absorption layer 3 after formation of this layer causes the Zn/Sn ratio of the surface part 3' to fall to 0.6 to 0.25. That is, if forming the Zn-based buffer layer 4 after SnCl treatment, the pn junction between the p-type CZTS-based light absorption layer 3 and the Zn-based buffer layer 4 is improved and the photovoltaic conversion output is improved.

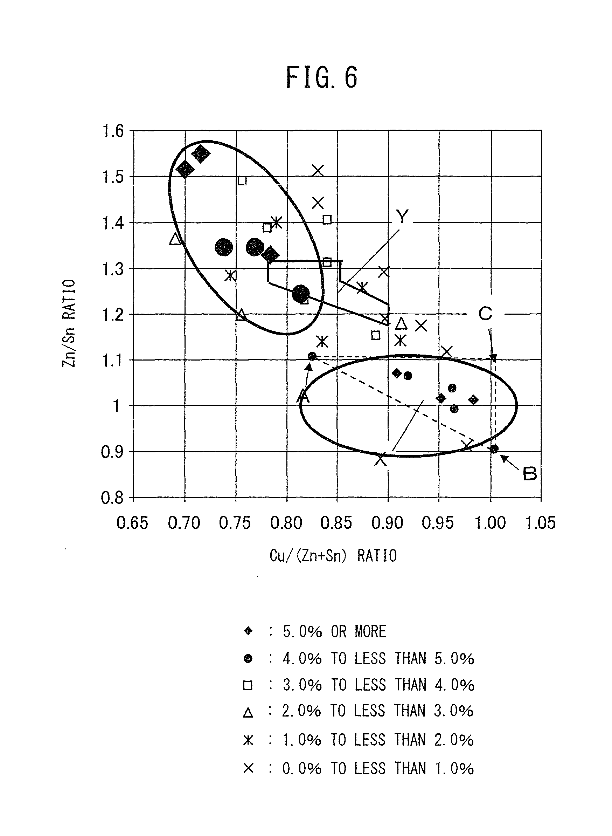

FIG. 6 plots Samples 30 to 37 which are shown in Table 4 on the graph which is shown in FIG. 3. As shown in FIG. 6, the newly manufactured Samples 30 to 37 are within the region Z on the extension of the region X. Among the samples of FIG. 2 which were manufactured without SnCl treatment, the samples in the region Z, that is, the Samples 9, 12, 15, 16, and 21, gave solar cells with a photovoltaic conversion efficiency (Eff) of 4% or less in each case. These were not considered suitable for practical application. However, in the Samples 30 to 37 of the present embodiment which were treated by SnCl, even if the Cu-Zn-Sn composition ratio was in the region Z, in each case a 4% or more high photovoltaic conversion efficiency could be achieved.

In the above way, the optimum composition ratio region X which is derived from the first embodiment and the optimum composition ratio region Z which is derived from the second embodiment greatly differ in the Cu-Zn-Sn composition ratio of the light absorption layer as a whole. However, in the samples of the second embodiment, SnCl treatment is performed to make the Zn/Sn ratio at the interface between the p-type CZTS-based light absorption layer 3 and the Zn-based buffer 4 greatly fall compared with the Zn/Sn ratio of the light absorption layer as a whole. On the other hand, the Zn/Sn ratio of the samples which achieve a high photovoltaic conversion efficiency in the first embodiment was about 1.11 or less in each case. From this, as a condition common to the samples of the first embodiment and the second embodiment, making the Zn/Sn ratio at the surface of the p-type CZTS-based light absorption layer at the Zn-based buffer layer side about 1.11 or less may be mentioned.

By adding the results of the samples according to the second embodiment under conditions making the Zn/Sn ratio of the surface of the light absorption layer 1.11 or less (Conditions R1), it is possible to set such an optimum composition ratio region R2 for a CZTS-based thin film solar cell. This region R2 is formed by connecting a point A which is specified from the samples of the first embodiment with a point D which can be specified from the samples of the second embodiment and connect a point C and a point E. The point D is one where the Cu/(Zn+Sn) ratio is about 0.65 and the Zn/Sn ratio is about 1.5, while a point E is one where the Cu/(Zn+Sn) ratio is about 0.75 and the Zn/Sn ratio is about 1.6.

Therefore, according to the present invention, in a CZTS-based thin film solar cell using a zinc compound for the n-type high resistance buffer layer, when expressing the Cu-Zn-Sn composition ratio by the value of Cu/(Zn+Sn) and the value of Zn/Sn, by setting this composition to a value in the region R2 which connects a point A (0.825, 1.108), a point B (1.004, 0.905), a point C (1.004, 1.108), a point E (0.75, 1.6), and a point D (0.65, 1.5) and, further, making the Zn/Sn ratio near the surface of the p-type CZTS-based light absorption layer at the Zn-based buffer layer side 1.11 or less, it is possible to obtain a Cd-free CZTS-based thin film solar cell which has a high photovoltaic conversion efficiency (Eff).

Note that, in the above second embodiment, as the method of adding Sn on the light receiving surface of the p-type CZTS-based light absorption layer, SnCl treatment is employed, but as the method for adding Sn to form a low Zn/Sn ratio region, there is the method of depositing Sn on the p-type CZTS-based light absorption layer 3 by vapor deposition, the method of depositing Sn by the ALD method, etc.

## Claims

1. A CZTS-based thin film solar cell comprising:
a metal back surface electrode layer formed on a substrate;
a p-type CZTS-based light absorption layer formed on the metal back surface electrode layer;
an n-type high resistance buffer layer made of a zinc compound and formed on the p-type CZTS-based light absorption layer; and
an n-type transparent conductive film formed on the n-type high resistance buffer layer,
wherein when expressing a Cu-Zn-Sn composition ratio (atomic ratio) of the p-type CZTS-based light absorption layer by coordinates using the Cu/(Zn+Sn) ratio as the abscissa and the Zn/Sn ratio as the ordinate, it is within a region connecting a point A (0.825, 1.108), a point B (1.004, 0.905), a point C (1.004, 1.108), a point E (0.75, 1.6), and a point D (0.65, 1.5), and
wherein further the Zn/Sn ratio of the surface of the p-type CZTS-based light absorption layer at the side which faces the n-type high resistance buffer layer is made 1.11 or less.

2. The CZTS-based thin film solar cell according to claim 1, wherein the zinc compound is Zn(S, O, OH).

3. The CZTS-based thin film solar cell according to claim 1 or 2, wherein the region of the surface of the p-type CZTS-based light absorption layer where the Zn/Sn ratio is 1.11 or less is made a 30 nm range from the interface of the n-type high resistance buffer layer.

4. A method of production of a CZTS-based thin film solar cell comprising:
forming a metal back surface electrode layer on a substrate;
forming on the metal back surface electrode layer a metal precursor film which includes at least Cu, Zn, and Sn which is selected so that, when expressed by coordinates using a Cu/(Zn+Sn) ratio as the abscissa and a Zn/Sn ratio as the ordinate, a Cu-Zn-Sn composition ratio (atomic ratio) falls in a region connecting a point A (0.825, 1.108), a point B (1.004, 0.905), a point C (1.004, 1.108), a point E (0.75, 1.6), and a point D (0.65, 1.5);
sulfurizing and/or selenizing the metal precursor film to form a p-type CZTS-based light absorption layer;
forming on the p-type CZTS-based light absorption layer an n-type high resistance buffer layer of a zinc compound; and
forming on the n-type high resistance buffer layer an n-type transparent conductive film,
wherein when the metal precursor film has a Zn/Sn ratio over 1.11, after formation of the p-type CZTS-based light absorption layer and before formation of the n-type high resistance buffer layer, the method performs treatment to add Sn to the surface of the p-type CZTS-based light absorption layer on the n-type high resistance buffer layer side so as to form a region with a Zn/Sn ratio of 1.11 or less, then form the n-type transparent conductive film.

5. The method according to claim 4, wherein the treatment to add Sn is dipping the p-type CZTS-based light absorption layer in an SnCl aqueous solution, then annealing it.

6. The method according to claim 4 or 5, wherein the zinc compound is Zn(S, O, OH).

7. The method according to claim 4 or 5, wherein the metal precursor film is formed by successively sputtering ZnS, Sn, and Cu in that order on the metal back surface electrodes.
